# EUROPÄISCHE PATENTANMELDUNG

(11) **EP 0 662 495 A1**
(43) Veröffentlichungstag der Anmeldung: **12.07.1995**
(21) Anmeldenummer: 94120767.2
(22) Anmeldetag: 27.12.1994
(51) Int. Cl.: C08K 5/523, C08L 101/00, C08L 63/02

(54) **Verwendung von funktionellen Gruppen enthaltenden Arylphosphaten als Flammschutzmittel für Polymere**

(30) Priorität: 10.01.1994 DE 4400441
(71) Anmelder: BAYER AG, 51368 Leverkusen (DE)
(72) Erfinder: Janke, Nikolaus, Dr., D-41539 Dormagen (DE); Peter, Rolf, Dr., D-41539 Dormagen (DE); Wunderlich, Hans, Dr., D-51373 Leverkusen (DE)

(57) **Zusammenfassung**

Arylphosphate der Formel 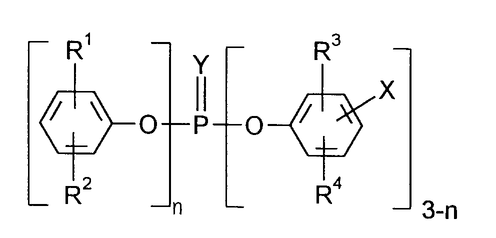
eignen sich besonders gut zur Verwendung als Flammschutzmittel für Polymere, insbesondere als Flammschutzmittel für Epoxidharze. Mit den beanspruchten Arylphosphaten wird die Flammwidrigkeit der damit ausgerüsteten Polymeren erhöht, ohne deren thermische und mechanische Eigenschaften wesentlich zu beeinträchtigen.

## Beschreibung

Die vorliegende Erfindung betrifft die Verwendung von funktionellen Gruppen-enthaltenden Arylphosphaten als Flammschutzmittel für Polymere.

Viele Polymere müssen aufgrund ihrer guten Brennbarkeit flammhemmend ausgerüstet werden. Eine Möglichkeit zur Erhöhung der Flammwidrigkeit von Polymeren ist die Zugabe nicht brennbarer oder schwer brennbarer Füllstoffe wie Glas, Quarzmehl, Wollastonit usw. zum Polymeren. Eine weitere Möglichkeit ist der Einsatz anorganischer Flammschutzmittel. Als Beispiele seien Borverbindungen und Metallhydroxide genannt. Für einen ausreichenden Flammschutz sind aber hohe Einsatzmengen derartiger Flammschutzmittel erforderlich. Dies führt zu großen Problemen bei der Herstellung und Verarbeitung von Reaktionsharzmassen.

Sehr weit verbreitet ist der Einsatz halogenierter Verbindungen, wie zum Beispiel Tetrabrombisphenol A, oder das entsprechende Bisepoxid daraus, Decabromdiphenylether bzw. bromierte Polystyrole. Die Verwendung halogenierter Flammschutzmittel ist jedoch umstritten. Bei der Verbrennung entstehen korrosive Gase wie Chlorwasserstoff oder Bromwasserstoff. Es besteht auch die Möglichkeit der Bildung stark toxischer, dioxinähnlicher Produkte.

Aus US 3 689 602, US 3 192 242, GB 1 487 609 und EP 465 605 ist die Verwendung von halogenhaltigen und auch halogenfreien Phosphaten als Flammhemmer für Polymere bekannt. Allerdings haben phosphororganische Verbindungen, die nicht in die Polymermatrix eingebaut werden, weichmachende Eigenschaften. Dies beeinträchtigt oft die mechanischen und elektrischen Eigenschaften der Polymere.

So werden z.B. die Festigkeitswerte bzw. der Glaspunkt erniedrigt. Manche dieser Verbindungen sind darüberhinaus thermisch instabil oder auch hydrolyseinstabil. Darüberhinaus sind die halogenhaltigen Phosphate, wie zuvor schon erwähnt, aus ökologischer Sicht umstritten.

Es wurde nun überraschend gefunden, daß die Verwendung von bestimmten, funktionelle Gruppen-enthaltenden Arylphosphaten oder Arylthiophosphaten eine Erhöhung der Flammwidrigkeit von Polymeren, insbesonderen Harzen, wie Epoxidharzen, bewirken, ohne deren thermische und mechanische Eigenschaften im wesentlichen zu beeinträchtigen.

Die vorliegende Erfindung betrifft daher die Verwendung von funktionellen Gruppen-enthaltenden Arylphosphaten der allgemeinen Formel 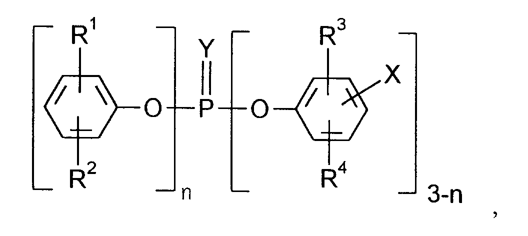
worin
- R¹ bis R⁴: unabhängig voneinander für Wasserstoff, Alkyl, Cycloalkyl, Alkenyl, Aryl oder Aralkyl stehen,
- Y: Sauerstoff oder Schwefel bedeutet,
- X: für OH, SH, COOH, COOR⁵, NH₂, NHR⁶, NR⁶R⁷ oder CN steht, wobei R⁵ bis R⁷ die für R¹ bis R⁴ angegebene Bedeutung haben, und
- n: für 0, 1 oder 2 steht.

Als Alkylreste R¹ bis R⁴ der vorstehenden Formel kommen insbesondere solche mit 1 bis 20, bevorzugt 1 bis 6, besonders bevorzugt 1 bis 4 Kohlenstoffatomen in Frage. Die Cycloalkylreste besitzen 5 bis 8, insbesondere 5 oder 6 Ringkohlenstoffatome, der Alkenylrest kann linear oder verzweigt sein und 2 bis 12, bevorzugt 2 bis 6 Kohlenstoffatome enthalten. Als Aryl-Substituenten kommen solche in Frage, die mit C₁-C₄-Alkylresten substituiert sind und 6 bis 14 Ringkohlenstoffatome besitzen. Selbstverständlich können die Aryl-Substituenten auch unsubstituiert sein. Als Aralkylgruppen sind solche bevorzugt, die 7 bis 12 Kohlenstoffatome enthalten.

Als Beispiele für die Reste R¹ bis R⁴ der vorstehenden Formel werden genannt: Methyl, Ethyl, Propyl, Isopropyl, n-Butyl, i-Butyl, t-Butyl, Pentyl, Hexyl, Octyl, Dodecyl, Tetradecyl, Eicosyl, Cyclopentyl, Cyclohexyl, Methylcyclohexyl, Vinyl, Prop-1-enyl, Prop-2-enyl, n-But-3-enyl, n-Pent-4-enyl, n-Hex-5-enyl, Phenyl, Naphthyl, Biphenyl, Benzyl, Methylbenzyl, Phenylethyl.

Besonders bevorzugt finden solche Arylphosphate der zuvor genannten Formel Verwendung, in der X für NH₂ steht und die Reste R¹ bis R⁴ Wasserstoff bedeuten und n für 1 oder 2 steht.

Die erfindungsgemäßen Verbindungen sind teilweise bekannt und können nach bekannten Methoden hergestellt werden. Eine Möglichkeit zur Herstellung der erfindungsgemäßen Verbindungen der vorstehenden Formel ist die Umesterung eines entsprechenden Triarylphosphates mit den entsprechenden Phenolen im geeigneten molaren Verhältnis unter basischer Katalyse (Houben-Weyl, Methoden der organischen Chemie, Band 12/2, S. 371 ff).

Die erfindungsgemäßen funktionelle Gruppen-enthaltenden Arylphosphate werden den Polymeren üblicherweise in Mengen von 1 bis 50 Gew.-%, bevorzugt 3 bis 40 Gew.-%, besonders bevorzugt 5 bis 30 Gew.-%, bezogen auf die Mengen des eingesetzten Polymeren, zugesetzt. Die optimale Menge an erfindungsgemäßen Arylphosphaten hängt von der Natur der Polymeren und der Art der eingesetzten Arylphosphate ab und kann leicht durch entsprechende Vorversuche ermittelt werden. Die erfindungsgemäßen Arylphosphate sind im allgemeinen schon bei geringen Zusatzmengen wirksam und beeinflussen daher die thermischen und mechanischen Eigenschaften der flammwidrig auszurüstenden Polymere praktisch nicht.

Die erfindungsgemäßen Arylphosphate können je nach Art des verwendeten Polymeren und den gewünschten Eigenschaften in verschiedener physikalischer Form angewendet werden. Sie können beispielsweise zum Erzielen einer besseren Dispersion im Polymeren zu einer feinteiligen Form vermahlen werden. Selbstverständlich ist es auch möglich, Gemische der verschiedenen erfindungsgemäßen Arylphosphate einzusetzen.

Polymere, die mit den erfindungsgemäßen Arylphosphaten flammwidrig gemacht werden können, sind z.B.:
1. Polyphenylenoxide und -sulfide sowie Gemische dieser Polymeren mit Polystyrolpfropfpolymeren oder Styrolcopolymeren, wie z.B. hoch schlagfestes Polystyrol, und EPDM-Copolymere mit Kautschuken, sowie Gemische von Polyphenylenoxiden mit Polyamiden und Polyestern.
2. Polyurethane, die sich von Polyethern, Polyestern oder Polybutadien mit endständigen Hydroxylgruppen einerseits und aliphatischen und aromatischen Polyisocyanaten andererseits ableiten, einschließlich Polyisocyanurate und Vorläufer davon.
3. Polyamide und Copolyamide, die sich von Diaminen und Dicarbonsäuren und/oder von Aminocarbonsäuren oder den entsprechenden Lactamen ableiten, wie Polyamid 4, Polyamid 6, Polyamid 6/6, Polyamid 6/10, Polyamid 11, Polyamid 12, Poly-2,4,4-trimethylenterephthalamid oder Poly-m-phenylenisophthalamid sowie Copolymere davon mit Polyethern, wie z.B. mit Polyethylenglykolen, Polypropylenglykolen oder Polytetramethylenglykolen.
4. Polyester, die sich von Dicarbonsäuren und Dialkoholen und/oder Hydroxycarbonsäuren oder den entsprechenden Lactonen ableiten, wie z.B. Polyethylenterephthalat, Polybutylenterephthalat, Poly- 1,4-dimethylol-cyclohexan-terephthalat und Polyhydroxybenzoate sowie Block-Copolyetherester, die sich von Polyethern mit endständigen Hydroxylgruppen ableiten.
5. Ungesättigte Polyester, die sich von Copolyestern aus gesättigten und ungesättigten Dicarbonsäuren und mehrwertigen Alkoholen und Vinylverbindungen als Vernetzungsmittel ableiten.
6. Polystyrol.
7. Pfropfcopolymere von Styrol, wie z.B. Styrol auf Polybutadien, Styrol und Acrylnitril auf Polybutadien, Styrol und Alkylacrylate oder -methacrylate auf Polybutadien, Styrol und Acrylnitril auf Ethylen/Propylen/Dien-Terpolymere, Styrol und Acrylnitril auf Acrylat/Butadien-Copolymere, sowie Gemische davon mit statistischen Copolymeren aus Styrol oder α-Methylstyrol und Dienen oder Acrylsäurederivaten, wie z.B. die als ABS, MBS, ASA oder AES bekannten Styrol-Terpolymere.
8. Polycarbonate.
9. Epoxidharze, die sich von Polyepoxiden ableiten, wie z.B. von Diepoxiden, insbesonders Bisphenol A-diepoxiden, oder von cycloaliphatischen Diepoxiden.

Die erfindungsgemäßen Arylphosphate eignen sich insbesondere zur Flammschutzausrüstung von Epoxidharzen, wie z.B. Bisphenol A-, Bisphenol F-, Phenol- und Kresol-Novolakepoxidharzen (siehe z.B. Houben-Weyl, Methoden der organischen Chemie, Bd. E 20/3, S. 1891 ff).

Der Vorteil bei der Anwendung der erfindungsgemäßen Arylphosphate zur Flammschutzausrüstung von beispielsweise Epoxidharzen besteht darin, daß die erfindungsgemäßen Phosphate in die Polymermatrix eingebaut werden und so die mechanischen und thermischen Eigenschaften der Formmassen nicht wesentlich beeinträchtigen. Ein weiterer Vorteil besteht darin, daß die Verbindungen der oben genannten Formel allein oder gemeinsam mit konventionellen Härtern für Epoxidharze eingesetzt werden können. Obwohl jeder der bekannten Härter für Epoxidharze verwendet werden kann, werden Anhydrid- und Aminhärter, wie sie beispielsweise in Houben-Weyl, Methoden der organischen Chemie, Bd. E 20/3, S. 1950 ff beschrieben sind, bevorzugt. Als Beispiele für Anhydridhärter werden genannt: Phthalsäureanhydrid, Hexahydrophthalsäureanhydrid, Methyltetrahydrophthalsäureanhydrid, Ethylhexahydrophthalsäureanhydrid und Methylnadicsäureanhydrid. Geeignete Aminhärter sind Dicyandiamid, 4,4'-Diaminodiphenyl-methan, 4,4'-Diamino-diphenyl-sulfon oder BF₃-Monoethylamin-Komplex. Die den Epoxidharzen zuzusetzenden Härtermischungen enthalten vorzugsweise 10 bis 80 Gew.-%, besonders bevorzugt 15 bis 60 Gew.-% an erfindungsgemäßen Arylphosphaten und 90 bis 20 Gew.-%, besonders bevorzugt 85 bis 40 Gew.-%, an einem der genannten Anhydrid- oder Aminhärter.

Die mit den erfindungsgemäßen Arylphosphaten ausgerüsteten Epoxidharzmassen, die halogenfrei sind, können insbesondere als Gieß- und Laminarharze für Umhüllungsmassen und für Leiterplatten im Elektronikbereich eingesetzt werden.

Selbstverständlich können die erfindungsgemäß flammhemmend ausgerüsteten Polymere noch weitere übliche Zusätze enthalten, wie z.B. Hitzestabilisatoren, Lichtstabilisatoren, UV-Absorber, Antioxidantien, Antistatika, Konservierungsmittel, Haftvermittler, Füllstoffe, Pigmente, Schmierstoffe, Verschäumungsmittel, Fungizide, Weichmacher, Verarbeitungshilfsmittel, weitere flammhemmende Zusätze und Mittel zur Verringerung der Rauchentwicklung. Als weitere flammhemmende Zusätze kommen beispielsweise phosphorhaltige Salze, wie z.B. Ammoniumpolyphosphate, Melamin und Melaminsalze, Salze aliphatischer und aromatischer Sulfonsäuren, Antimontrioxid, Aluminiumhydroxid, Wismutphosphat, Molybdänoxid, Tetrafluorethylenpolymerisate oder Gemische dieser Verbindungen mit Zink- und/oder Magnesiumoxid oder -salzen in Frage.

Die Erfindung wird durch die folgenden Beispiele näher erläutert:

### Beispiel 1

In einem 1 l Zweihalskolben werden 489 g (1,5 mol) Triphenylphosphat, 327 g (3,0 mol) 3-Aminophenol und 0,9 g (22,5 mmol) Natriumhydroxid vorgelegt und unter Rühren bis auf 200°C erhitzt. In 4 Stunden werden bei einem Druck von 30 hPa 279 g Phenol über eine Vigreux-Kolonne abdestilliert. Das Reaktionsprodukt wird aus Ethanol umkristallisiert.
Ausbeute: 430 g (81 %)
Fp.: 115 bis 125°C

### Beispiele 2 bis 6

100 Gew.-Teile eines Epoxidharzes auf Basis Bisphenol A mit einem Epoxidgehalt von 5,1 bis 5,4 Epoxidgruppen/kg werden mit den entsprechenden Gewichtsteilen Härtern bzw. Härtergemisch gemäß Tabelle 1 versetzt und 15 Minuten in einem Vakuumtrockenschrank bei 100°C entgast. Anschließend wird das Gemisch in eine auf 100°C vorgewärmte Metallgießform (6 Prüfkörper L = 150 mm, B = 6,5 mm, H = 3,0 mm) gegossen und in 1,5 Stunden bei 160°C und 1,5 Stunden bei 180°C gehärtet.

Zur Ermittlung der Flammhemmung wird von den Prüfkörpern der Sauerstoffindex gemäß ASTM D 2863 bestimmt (LOI).

Weiterhin wird der Glaspunkt T_{g} mittels DSC-Methode (Differential Scanning Calorimetry) gemessen. Angegeben ist jeweils der 2. Durchgang.

Ebenso wird eine thermogravimetrische Messung durchgeführt, wobei der Gewichtsverlust bei 5 % und 10 % bestimmt wird.

Die Resultate sind in Tabelle 1 angegeben.

**Tabelle 1**

| Beispiel | 2 | 3 | 4 | 5 | 6 |
|---|---|---|---|---|---|
| DDS* | 33,0 | 26,4 | 22,0 | 16,5 | - |
| Beispiel 1 (Phosphat) | - | 8,5 | 14,2 | 23,6 | 47,2 |
| LOI (%) | 22 | 25 | 26 | 25 | 25 |
| T_{g} (°C) | 185 | 172 | 160 | 156 | 140 |

| Thermogravimetrie | | | | | |
|---|---|---|---|---|---|
| t (-5Gew.-%) (°C) | 405 | 382 | 368 | 370 | 360 |
| t (-10Gew.-%) (°C) | 412 | 387 | 372 | 374 | 361 |

| | | | | | |
|---|---|---|---|---|---|
| * 4,4'-Diaminodiphenylsulfon | | | | | |

## Patentansprüche

1. Verwendung von funktionellen Gruppen-enthaltenden Arylphosphaten der Formel 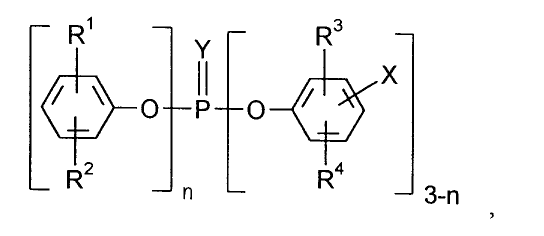 worin
R¹ bis R⁴ unabhängig voneinander für Wasserstoff, Alkyl, Cycloalkyl, Alkenyl, Aryl oder Aralkyl stehen,
Y Sauerstoff oder Schwefel bedeutet,
X für OH, SH, COOH, COOR⁵, NH₂, NHR⁶, NR⁶R⁷ oder CN steht, wobei R⁵ bis R⁷ die für R¹ bis R⁴ angegebene Bedeutung haben, und
n für 0, 1 oder 2 steht.
als Flammschutzmittel für Polymere.

2. Verwendung der Arylphosphate gemäß Anspruch 1 als Flammschutzmittel für Polymere in Mengen von 1 bis 50 Gew.-%, bezogen auf die eingesetzten Polymere.

3. Verwendung der Arylphosphate gemäß Ansprüchen 1 und 2 als Flammschutzmittel für Epoxidharze.
